# DEMANDE DE BREVET EUROPEEN

(11) **EP 0 828 163 A1**
(43) Date de publication de la demande: **11.03.1998**
(21) Numéro de dépôt: 97410101.6
(22) Date de dépôt: 09.09.1997
(51) Int. Cl.: G01R 31/3185, G06F 11/267

(54) **Circuit comprenant des moyens de test structurel sans plot de test dédié au test**

(30) Priorité: 10.09.1996 FR 9611228
(71) Demandeur: SGS-THOMSON MICROELECTRONICS S.A., 94250 Gentilly (FR)
(72) Inventeur: Cauchy, Xavier, 38000 Grenoble (FR)
(74) Mandataire: de Beaumont, Michel

(57) **Abrégé**

L'invention propose un circuit (1) apte à fonctionner selon un mode de fonctionnement normal ou un mode de test structurel. Le mode de test est mémorisé dans une bascule (TESTREG) interne par le biais d'une interface du circuit (6, DECOD). En mode de test, la bascule est isolée de l'interface par des moyens de multiplexage (MUX3). Pour sortir du mode de test, on utilise une entrée (IP2) temporairement dédiée à cette fonction, cette entrée étant alors isolée par des moyens de multiplexage (MUX2) du reste (EL2) du circuit.

## Description

L'invention concerne le domaine du test structurel des circuits intégrés logiques, ou comprenant des parties logiques.

La production de circuits intégrés comprend généralement des étapes de test des circuits produits, une fois ceux-ci fabriqués. Ces tests sont habituellement de deux types : les tests structurels d'une part, et les tests fonctionnels d'autre part. Les tests structurels consistent à vérifier que les circuits ne présentent pas de défauts physiques les rendant inopérants. Ces défauts sont indépendants des applications des circuits. Les tests fonctionnels consistent à vérifier, pour les circuits ne présentant pas de défauts physiques, que ces circuits fonctionnent correctement pour les applications auxquelles ils sont destinés.

Dans les circuits logiques, l'effet des défauts physiques est représenté par un modèle de faute sur un niveau logique. Le modèle le plus largement utilisé est le modèle dit de collage (stuck-at-fault en langue anglaise), dans lequel un noeud électrique du circuit garde toujours le même état logique (en logique binaire : l'état bas pour un collage à 0 et l'état haut pour un collage à 1), indépendamment des états des signaux logiques qui contrôlent ce noeud. Si on considère par exemple une porte logique de type ET à deux entrées ayant une entrée bloquée à l'état bas (collage à 0), le signal produit par la porte sera toujours à l'état bas quel que soit l'état du signal reçu par l'autre entrée.

Pour pouvoir détecter une faute sur un noeud, il faut que ce noeud soit contrôlable et observable. Idéalement, il faut que tous les noeuds d'un circuit logique à tester soient contrôlables et observables.

La contrôlabilité est la capacité à pouvoir imposer sur chaque noeud interne du circuit logique un état logique donné, à partir de l'état logique des entrées/sorties primaires du circuit. Par entrées/sorties primaires d'un circuit, on entend les noeuds du circuit accessibles de l'extérieur de ce circuit, c'est-à-dire connectés directement à des plots d'accès. L'état de ces noeuds peut être contrôlé (c'est-à-dire imposé et/ou observé) directement par une machine de test.

L'observabilité est la capacité à pouvoir propager les états logiques des noeuds internes vers des broches du circuit, ce qui rend possible une analyse a posteriori de la structure du circuit.

Classiquement, on soumet les circuits logiques à des motifs de test. Un motif correspond à un ensemble d'états logiques qu'on applique aux entrées primaires du circuits, et à un ensemble d'états logiques fournis par les sorties primaires en réponse aux états reçus par le circuit. Pour un circuit donné, les états fournis par le circuit sont comparés aux états attendus, ces états attendus étant calculés d'après les équations logiques du circuit et d'après l'ensemble des états fournis au circuit. Il y a succès si les états fournis par le circuit coïncident avec les états attendus. Toute différence indique qu'il y a un défaut de fabrication du circuit.

Si on considère le modèle du collage, un motif de test doit pouvoir permettre de détecter autant de collages que possible, s'il y en a. Pour ce faire, on essaie de mettre sur chaque noeud contrôlable du circuit une valeur logique et on vérifie que la valeur forcée a bien été prise en compte. Par exemple, si un noeud est bloqué à l'état bas, il faudra pour le détecter utiliser un motif qui le forcerait à l'état haut si il n'était pas bloqué. Ensuite, le motif de test doit propager l'effet de la faute vers une sortie où on peut en observer la conséquence (soit directement si le noeud est accessible, soit indirectement si on observe un noeud placé en aval du noeud défaillant).

Pour les petits circuits combinatoires, des motifs de test avec une couverture de fautes de 100% (toutes les fautes potentielles sont détectables) sont relativement faciles à développer, même une fois le circuit fabriqué.

Par contre, le test d'un gros circuit séquentiel est plus compliqué et peut nécessiter l'application d'un ensemble complexe de motifs ordonnés d'une manière spécifique. Pour simplifier le test on tend à prendre en compte, dès les étapes de conception de la structure du circuit, la mise en oeuvre des tests structurels, par exemple en insérant dans les circuits des circuits internes dédiés au test.

Une solution classique est d'insérer un ou des registres de test à décalage, ce qui permet généralement une excellente couverture de fautes. Ce ou ces registres de test sont formés de bascules reliées en série les unes avec les autres, ces bascules étant positionnées au niveau de noeuds à tester de sorte à pouvoir imposer et/ou échantillonner les états logiques de ces noeuds.

On pourra utiliser des bascules spécifiquement dédiées au test.

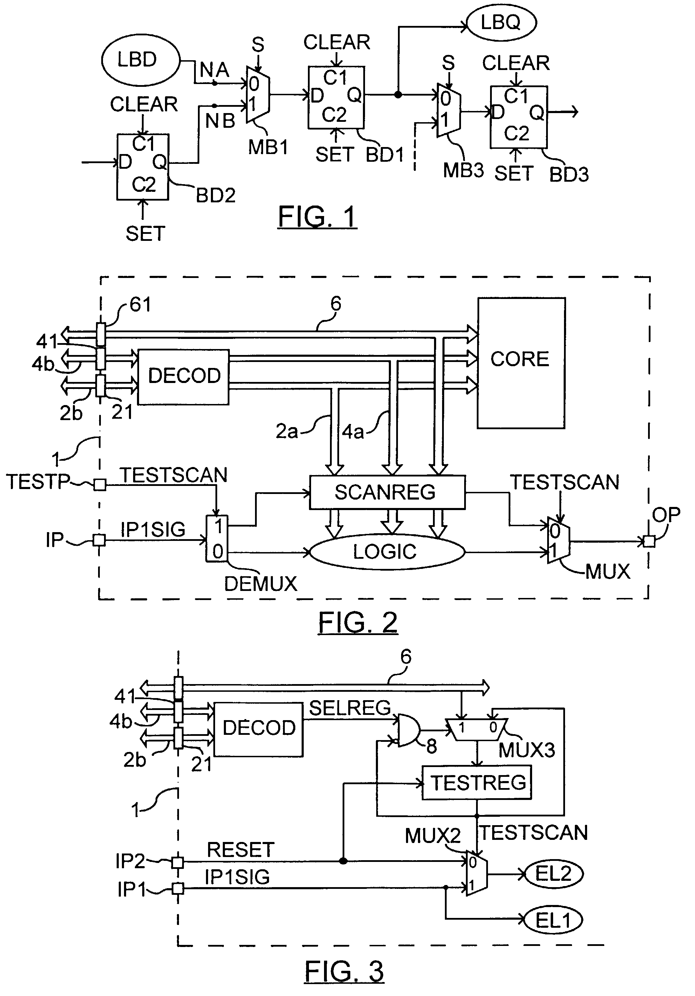

On peut également utiliser des bascules utilisées en mode de fonctionnement normal et en mode de test. Ce cas est illustré sur la figure 1. Dans ce dernier cas, on place alors typiquement en entrée de ces bascules des circuits de multiplexage afin de connecter sélectivement leur entrée selon le mode choisi, c'est-à-dire selon que l'entrée doit être reliée à la sortie d'une bascule en mode de test, ou à un autre noeud en mode de fonctionnement normal. Ainsi, sur la figure 1, une bascule D référencée BD1 a une entrée D, une sortie Q, et deux entrées de commande C1 et C2 pour recevoir un signal SET de mise à l'état haut et un signal CLEAR de mise à l'état bas. L'entrée D est reliée à la sortie d'un multiplexeur MB1 a deux entrées. Les entrées du multiplexeur MB sont reliées à deux noeuds DA et DB. Un signal de sélection S permet de relier l'entrée D de la bascule soit au noeud NA, soit au noeud NB. Le noeud NA correspond par exemple à une sortie d'un circuit LBD de portes combinatoires. Le noeud NB correspond par exemple à une sortie d'une bascule BD2 qui pourra être dédiée au test ou pourvue comme la bascule BD1 d'un multiplexeur en entrée. La sortie Q de la bascule BD1 est reliée à une entrée d'un circuit LBQ de portes combinatoires et à une entrée d'une bascule BD3 par le biais d'un multiplexeur MB3. En mode de test, on relie l'entrée D de la bascule BD1 au noeud NB et on relie sa sortie Q à l'entrée de la bascule BD3. En mode de fonctionnement normal, on relie l'entrée D au noeud NA.

Une séquence de test peut se décomposer en quatre étapes :
1 - en mode de test, par une série de décalages dans les bascules formant le ou les registres de test, on amène les états à imposer aux noeuds voulus. Le circuit est alors inopérant.
2 - on remet le circuit en mode de fonctionnement normal. Les états imposés se combinent entre eux pour créer des états qui sont fonction de la structure et du caractère défaillant ou non des éléments logiques du circuit.
3 - on échantillonne tout ou partie des états résultants dans les bascules de test.
4 - les valeurs échantillonnées sont extraites du circuit par décalage dans ces bascules pour être analysées.

Un problème posé par les systèmes de test employés est notamment l'impact de ces systèmes sur le prix des circuits, alors même qu'ils ne sont employés que brièvement en début de vie des circuits.

Les entrées/sorties primaires disponibles pour le test sur un circuit sont généralement une ressource rare, particulièrement pour les circuits comprenant peu d'entrées/sorties primaires. Ce problème est d'autant plus contraignant que les circuits sont encapsulés dans des boîtiers dont le nombre de broches est standardisé. Changer le nombre de broches peut entraîner une variation importante de la surface du boîtier, donc du prix des circuits. Il peut arriver que l'élimination d'une seule entrée/sortie puisse permettre d'utiliser un boîtier plus petit (on passera par exemple de 12 broches à 8 broches) et donc de diminuer dans une proportion non négligeable le prix du circuit.

Il apparaît donc fort intéressant de pouvoir se passer d'entrées/sorties dédiées exclusivement au test.

Une solution est de tester les circuits uniquement sous l'aspect fonctionnel, c'est-à-dire pratiquement à utiliser le circuit en mode de fonctionnement normal, dans l'application à laquelle il est destiné. Cette solution présente l'inconvénient de nécessiter beaucoup de temps et d'énergie pour mettre au point des stimuli qui assurent une couverture de fautes satisfaisante, particulièrement pour les circuits complexes.

Une autre solution, largement employée, est de multiplexer la plupart des entrées/sorties primaires de test avec des broches fonctionnelles, c'est-à-dire qu'une même entrée/sortie reçoit ou fournit un signal à des éléments internes pouvant être différents en mode de fonctionnement normal et en mode de test. Une seule broche du circuit est dédiée au test pour fournir le signal qui contrôle le multiplexage.

Une solution pour éliminer cette broche dédiée est de la remplacer par un bit de programmation représentatif du mode, autrement dit par une bascule d'un registre interne de commande, programmable de l'extérieur par le biais d'une interface composée typiquement de bus de données, d'adresses et de commande.

Cette solution, de type logicielle, présente plusieurs inconvénients :
- il faut garantir que le contenu de cette bascule ne sera pas modifié lors du chargement par décalage des bascules de test, auquel cas on bloquerait ce chargement dès que la valeur du bit de programmation correspondrait au mode fonctionnel. La bascule doit donc être placée en dehors des chemins de décalage utilisés pour le test,
- il faut pouvoir garantir que le contenu de cette bascule ne sera pas modifié de manière intempestive lors des étapes de test effectuées en mode fonctionnel,
- il faut pouvoir garantir un accès à cette bascule afin de pouvoir en modifier le contenu, quand on souhaite modifier de l'extérieur le mode employé.

Une solution pour pallier à ces inconvénients est d'isoler l'interface du circuit à tester qui est mise en oeuvre pour accéder à la bascule. Cela risque de diminuer de manière non négligeable la couverture de fautes, les noeuds du circuit reliés à cette interface n'étant plus testés.

Compte tenu de ce qui précède, un but de l'invention est de proposer une solution de type logicielle permettant de supprimer toute entrée dédiée exclusivement à la commande du mode de fonctionnement, sans diminuer la couverture de fautes, et en assurant de pouvoir contrôler le mode de fonctionnement des circuits depuis l'extérieur.

Pour ce faire on propose :
- d'isoler, quand on rentre en mode de test, un premier plot des éléments internes auxquels il est relié en mode de fonctionnement normal, ces éléments étant reliés à un deuxième plot se substituant au premier plot, et
- de commander la sortie du mode de test par ce premier plot, le registre mémorisant le mode mis en oeuvre étant d'une part sensible à l'état présent sur celui-ci, et d'autre part isolé de l'interface en mode de test.

L'entrée primaire correspondant au premier plot sera par exemple l'entrée de commande de réinitialisation (ou reset) dont les circuits logiques, ou comprenant des parties logiques, sont généralement pourvus. L'invention permet d'utiliser cette entrée pour commander temporairement la sortie du mode de test, sans entraîner de diminution de la couverture de fautes.

Ainsi l'invention propose un circuit apte à fonctionner selon au moins un premier et un deuxième modes de fonctionnement, comprenant des moyens d'interface avec l'extérieur, une cellule de mémorisation programmable par le biais des moyens d'interface du circuit, le contenu de la cellule étant représentatif du mode de fonctionnement du circuit, une première entrée reliée d'une part à la cellule pour pouvoir en modifier le contenu de sorte à modifier le mode, et d'autre part à un ou des éléments du circuit, une deuxième entrée, et des moyens de multiplexage commandés par la cellule pour d'une part relier sélectivement ce ou ces éléments à la deuxième entrée quand le circuit est dans le premier mode et à la première entrée dans le deuxième mode, et d'autre part pour isoler la cellule des moyens d'interface quand le circuit est dans le premier mode.

D'autres avantages et particularités apparaîtront à la lecture de la description qui suit d'un exemple de réalisation de l'invention, à lire conjointement aux dessins annexés dans lesquels :
- la figure 1 illustre un exemple de circuit utilisant des bascules utilisées dans un mode de fonctionnement normal et dans un mode de test par décalage,
- la figure 2 illustre schématiquement un circuit comprenant des moyens de test par décalage et une broche de commande de test,
- la figure 3 illustre le circuit tel qu'illustré sur la figure 1, modifié de sorte à mettre en oeuvre l'invention.

La figure 2 illustre un exemple très schématique de mise en oeuvre de test par registre à décalage selon l'état de la technique. Un circuit 1 comprend un processeur CORE et un ensemble LOGIC de circuits logiques. Le processeur et les circuits logiques sont reliés ensemble par des bus 2a, 4a et 6 de commande, d'adresses et de données. Le bus de données est accessible à l'extérieur du circuit par un port d'entrée/sortie 61. Un circuit d'interface DECOD assure l'interface entre les bus interne 2a et 4a de commande et d'adresses et des bus 2b et 4b de commande et d'adresses reliés à l'extérieur du circuit par des ports d'entrée/sortie 21 et 41.

Un registre interne SCANREG à décalage permet d'échantillonner ou d'imposer des états sur les bus internes 2a, 4a et 6.

Le circuit comprend enfin une entrée primaire IP, une sortie primaire OP et une entrée primaire TESTP de commande de test qui fournit un signal TESTSCAN de commande de test. L'entrée IP est reliée par le biais d'un démultiplexeur DEMUX d'une part à une entrée de l'ensemble LOGIC, et d'autre part à l'entrée du registre SCANREG. La sortie OP est reliée par le biais d'un multiplexeur MUX d'une part à une sortie de l'ensemble LOGIC, et d'autre part à la sortie du registre SCANREG. L'entrée TESTP permet de commander les circuits MUX et DEMUX selon que le circuit est en mode de fonctionnement normal (TESTSCAN = 0) ou en mode de test (TESTSCAN = 1), pour relier sélectivement les entrées IP et OP à l'ensemble LOGIC ou au registre SCANREG.

Par rapport au circuit de la figure 2, le circuit de la figure 3 comprend une cellule de mémorisation programmable, interne au circuit, pour mémoriser le mode de fonctionnement (normal ou de test) du circuit.

Cette cellule est par exemple une bascule TESTREG. Cette bascule a une entrée reliée au bus de données de sorte que son état puisse être programmé depuis l'extérieur du circuit quand un signal de sélection SELREG fourni par le circuit d'interface sur le bus 2a est dans un état donné. L'état (TESTSCAN) mémorisé dans la bascule est fourni aux éléments internes du circuit impliqués dans le test, tels que les circuits de multiplexage et de démultiplexage destinés au test.

Le registre TESTREG commande un multiplexeur MUX2 à deux entrées ayant ses entrées reliées à deux entrées primaires IP1 et IP2 du circuit. Les entrées IP1 et IP2 sont reliées à un ou plusieurs éléments internes du circuit 1, référencés respectivement EL1 et EL2. L'entrée IP2 est également reliée à une entrée d'effacement de la bascule TESTREG. L'entrée IP2 sera par exemple une entrée de commande de réinitialisation du circuit 1 qui permet, en mode de fonctionnement normal, de mettre le ou les éléments EL2 du circuit dans un état déterminé en leur fournissant un signal de réinitialisation RESET. L'entrée IP1 fourni elle un signal noté IP1SIG au ou aux éléments EL1.

En mode de test, le signal IP1SIG est fourni au ou aux éléments EL2 par le biais du multiplexeur MUX2, qui isole alors l'entrée IP2. Ce ou ces éléments sont donc accessibles depuis l'extérieur du circuit. L'entrée IP1 se substitue alors à l'entrée IP2. On notera que l'on pourra éventuellement isoler l'entrée IP1 du ou des éléments EL1 en mode test, si cette entrée n'est pas utilisée pour échanger des états avec un registre de test. Sur la figure 3, en mode de test, l'entrée IP1 est reliée à la fois au ou aux éléments EL1 et EL2. En pratique, le fait que l'entrée IP1 est utilisée pour fournir en mode de test un signal à un ou des éléments du circuit auquel elle n'est pas reliée en mode de fonctionnement normal est peu gênant puisque le test structurel consiste à vérifier que les circuits logiques marchent correctement, indépendamment de savoir si cette vérification est représentative d'un fonctionnement normal du circuit. Il s'agit seulement de vérifier qu'aucun collage n'est présent sans que la provenance physique du signal fourni au circuit pour détecter un collage ait la moindre importance.

L'entrée IP2 est utilisée pour commander, quand le circuit est en mode de test, l'effacement de la bascule TESTREG de sorte que le circuit puisse repasser en mode de fonctionnement normal, ce qui permet de reprendre depuis l'extérieur le contrôle du circuit en cours ou en fin de test. En mode de test, cette entrée est dédiée temporairement au test.

On notera que l'on aurait pu utiliser des sorties primaires ou des entrées/sorties primaires du circuit 1 en lieu et place des entrées IP1 et IP2. On remplacera alors éventuellement le multiplexeur MUX par un démultiplexeur.

Pour garantir une couverture de fautes convenable, on isole la bascule TESTREG, ce qui permet d'imposer ou d'échantillonner les signaux présents sur les bus internes lors du test structurel. Pour ce faire, on utilise un multiplexeur MUX3 à deux entrées dont la sortie est reliée à l'entrée de la bascule TESTREG, dont une entrée est reliée au bus 6 et dont l'autre entrée est reliée à la sortie de la bascule qui fournit le signal TESTSCAN. Ce multiplexeur est commandé par une porte logique 8 de type ET qui reçoit le signal SELREG sur une entrée et le signal TESTSCAN sur une entrée inverseuse. Ainsi, quand on est en mode de test, l'entrée et la sortie de la bascule sont reliées, et la bascule est isolée de l'interface du circuit. Quand on est en mode de fonctionnement normal, la bascule est accessible par le biais du bus 6.

L'invention permet de combiner les avantages du test structurel à l'aide de registres à décalage, économique en termes de temps et d'énergie consacrés au développement des motifs de test, avec la possibilité de supprimer toute entrée/sortie dédiée spécifiquement au test, ce qui permet d'envisager une utilisation de boîtiers de dimensions inférieures (si le facteur déterminant dans la taille du boîtier est le nombre de broches de connexion utilisées et non la taille du circuit semi-conducteur encapsulé). Elle ne diminue pas la couverture de fautes et ne nécessite pas un nombre important d'éléments internes au circuit pour compenser la non utilisation d'une entrée primaire dédiée au test.

Bien que trouvant une application particulièrement intéressante dans le domaine du test structurel, l'invention permet plus généralement, pour un circuit comprenant au moins deux modes de fonctionnement, de contrôler de manière sûre le mode de fonctionnement du circuit sans utiliser de broche dédiée exclusivement à cette commande.

## Revendications

1. Circuit (1) apte à fonctionner selon au moins un premier et un deuxième modes de fonctionnement, comprenant :
- des moyens (6, DECOD) d'interface avec l'extérieur,
- une cellule de mémorisation (TESTREG) programmable par le biais des moyens d'interface du circuit, le contenu de la cellule étant représentatif du mode de fonctionnement du circuit,
- une première entrée (IP2) reliée d'une part à la cellule pour pouvoir en modifier le contenu de sorte à modifier le mode, et d'autre part à un ou des éléments (EL2) du circuit,
- une deuxième entrée (IP1), et
- des moyens de multiplexage (MUX2, MUX3) commandés par la cellule pour d'une part relier sélectivement ce ou ces éléments (EL2) à la deuxième entrée (IP1) quand le circuit est dans le premier mode et à la première entrée (IP2) dans le deuxième mode, et d'autre part pour isoler la cellule des moyens d'interface quand le circuit est dans le premier mode.

2. Circuit selon la revendication 1, caractérisé en ce que la cellule est une bascule (TESTREG) dont une entrée est reliée à un multiplexeur (MUX3) commandé par une sortie de la bascule de telle sorte que l'entrée de la bascule est reliée d'une part à sa sortie quand l'état de sa sortie est représentative du premier mode, et à l'interface du circuit quand l'état de sa sortie est représentative du deuxième mode.

3. Circuit selon l'une des revendications 1 ou 2, caractérisé en ce que le premier mode est un mode de test structurel, et en ce que le deuxième mode est un mode de fonctionnement normal.
